# EUROPEAN PATENT SPECIFICATION

(11) **EP 2 714 255 B1**
(45) Date of publication and mention of the grant of the patent: **13.05.2015**
(21) Application number: 12727484.3
(22) Date of filing: 30.05.2012
(51) Int. Cl.: B01F 13/00, B01F 5/00, B01F 5/02

(54) **TWIST FLOW MICROFLUIDIC MIXER AND MODULE**
MIKROFLUIDISCHER DRALLSTRÖMUNGSMISCHER UND MODUL
MÉLANGEUR ET MODULE MICROFLUIDIQUE À ÉCOULEMENT ENROULÉ

(30) Priority: 31.05.2011 US 201161491506 P
(43) Date of publication of application: 09.04.2014
(73) Proprietor: Corning Incorporated, Corning, New York 14831 (US)
(72) Inventor: CHIVILIKHIN, Mikhail Sergeevich, St. Petersburg 191124 (RU)
(74) Representative: Greene, Simon Kenneth
(86) International application number: PCT/US2012/039916
(87) International publication number: WO 2012/166756

(56) References cited:
- WO-A1-2008/056975
- DE-A1-102006 016 482
- KOCKMANN N ET AL: "Convective mixing and chemical reactions in microchannels with high flow rates", SENSORS AND ACTUATORS B: CHEMICAL: INTERNATIONAL JOURNAL DEVOTED TO RESEARCH AND DEVELOPMENT OF PHYSICAL AND CHEMICAL TRANSDUCERS, ELSEVIER S.A, SWITZERLAND, vol. 117, no. 2, 12 October 2006 (2006-10-12), pages 495-508, XP027971686, ISSN: 0925-4005 [retrieved on 2006-10-12]

## Description

### BACKGROUND

This application claims the benefit of priority under 35 USC § 119 of US Provisional Application Serial No. 61/491,506 filed on May 31, 201.

### FIELD

This disclosure relates to mixers and fluidic modules for mixing in continuous flow reactors, including those mixers or mixer modules having fluid channels with cross-sectional dimensions in sub-millimeter to about 20 millimeter range, and to such modules or mixers inducing or designed to induce an axial twist flow in fluids flowing therethrough.

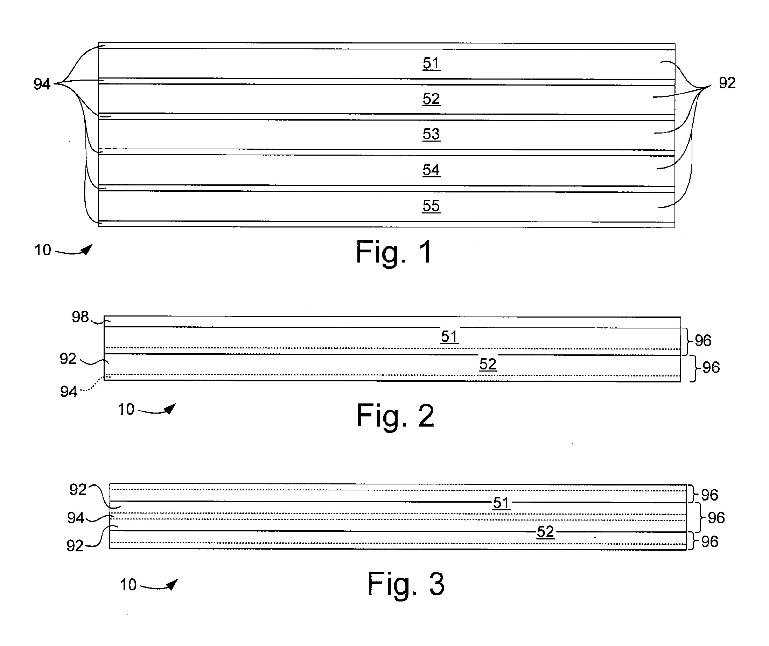

A common form for a microfluidic device is a stack of substrates with micro-fluidic channels formed inside or between the substrates. Some selected types of stacks are shown in Figs. 1-4. Fig. 1 is an elevation view of a stack of substrates forming a fluidic module 10. In Fig. 1, a the fluidic module 10 is built up of five relatively thicker wall substrates or wall structures 92 that are stacked between six relatively thinner plate substrates or floor structures 94. The wall substrates 92 define fluid passages within the microfluidic module, while the plate substrates provide support and optionally also form the floors and ceilings of fluid passages defined laterally by the wall substrates 92. Plate and wall substrates may be formed separately, then stacked and sealed or fused permanently together, or sealed temporarily, such as by compression or other means. The wall substrates or wall structures 92 may also be formed or structured directly on the plate substrates 94, such as in the methods and processes for making microreactors and microfluidic modules shown and disclosed in U.S. Patent No. 7,007,709, assigned to the present assignee. As generally described therein, the wall substrates or wall structures 92 may be formed on one or both sides of the plate substrates 94. In the case of the module 10 of Fig. 1, the resulting module 10 includes five layers 51, 52, 53, 54, 55 in which fluid passages may be, and are desirably defined.

Alternative processes for forming the wall substrates or wall structures 92 and the plate substrates 94 are many, including virtually any type of machining or other forming methods (molding, casting, pressing) that are appropriate to the materials that may be chosen. Materials that may be useful to form the wall structures 92 and the plate substrates 94 are likewise many, ranging from highly chemically resistant materials such as glass and ceramic, to highly thermally conductive materials such as metal and some ceramics, to low-cost materials such as plastic materials, depending on the desired use with appropriate regard for chemical and process compatibility. Sealing may be by fusion, sealing with a frit-forming or brazing agent, diffusion bonding, chemical welding, and so forth, as may be suitable for the intended use.

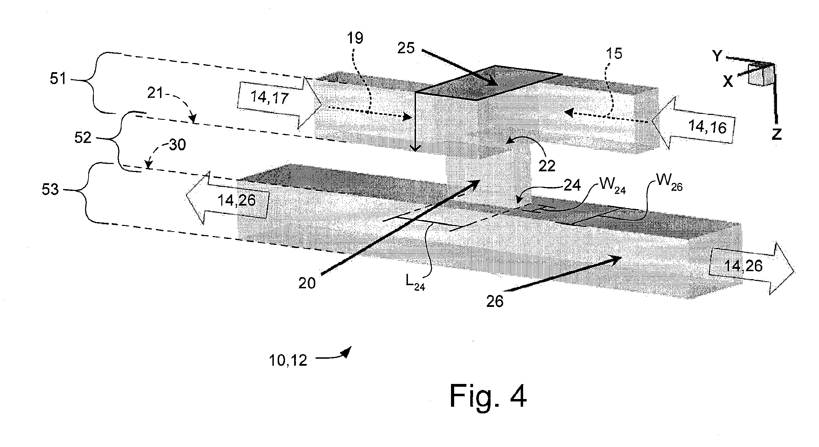

Forming or machining or the like may also be used to produce formed substrates 96 that include both a wall structure 92 and a floor structure 94 in one piece. Such formed substrates 96 may include wall a structure 92 on only one side, and may be sealed to a plate substrate lid 98 and/or to another formed substrate 96, as shown in Fig. 3, or may include wall structure 92 on both sides, such as in the case of the central formed substrate 96 in Fig. 4 sealed on both faces to a formed substrate 96 with wall structure 92 on one side only.

Such layered structures and layered fabrication techniques provide good flexibility in the choice and placement of fluid channels within the resulting fluid modules 10. It is desirable to have a fluid channel arrangement for such modules that is easily produced within a stacked structure and utilizes a high proportion of the available volume of the module, while allowing for very good mixing while minimizing pressure drop.

Where high thermal conductivity materials are used to form the fluidic module 10, it is also desirably to minimize the effective thermal resistance of the fluid within the module to successfully utilize the benefits of high thermal conductivity walls.

Document KOCKMANN N ET AL: "Convective mixing and chemical reactions in microchannels with high flow rates", SENSORS AND ACTUATORS B: CHEMICAL: INTERNATIONAL JOURNAL DEVOTED TO RESEARCH AND DEVELOPMENT OF PHYSICAL AND CHEMICAL TRANSDUCERS, ELSEVIER S.A, SWITZERLAND, vol. 117, no. 2, 12 October 2006 (2006-10-12), pages 495-508, ISSN: 0925-4005, discloses multilayer microfluidic module according to the preamble of claim 1.

The present application discloses a new mixing device with a fluid path design that can provide low pressure drop and high mixing quality, with easy manufacturability within a stacked structure fluidic module, and can also help minimize the effective thermal resistance of the fluid flowing within the module.

### SUMMARY

According to an aspect of the present disclosure, a multilayer microfluidic module contains a micromixer comprising, in order along an internal fluid path, a first fluid channel lying within a first layer of the module along a first direction with the first layer having a lower boundary;at least one additional fluid channel lying within the first layer of the module along an additional direction; a first injection passage extending from a first injection passage inlet in the lower boundary of the first layer of the module through a second layer of the module to a first injection passage outlet, the first injection passage inlet being fluidically connected to the first fluid channel and to the additional fluid channel either individually through the lower boundary of the first layer or via a manifold within the first layer; and a second fluid channel lying within a third layer of the module, the third layer having an upper boundary, the second fluid channel having a width W₂₆; wherein the first direction and the additional direction are non-collinear, and wherein the first injection passage outlet is centered within the second fluid channel in the direction of the width W₂₆, and has a length L₂₄ along the second fluid channel and a width W₂₄ in the direction of the width W₂₆, and wherein the width W₂₄ is narrower than the width W₂₆, and wherein the first injection passage outlet has a length-to-width ratio L₂₄ / W₂₄ of greater than 1:1, desirably 2:1 or more. The structures according to this aspect of the disclosure induce axial circulations sequentially along sections of fluid channel not lying in the same plane, such that vortexes are formed sequentially at angles to each other, desirably at right angles, producing a further increase in the resulting interfacial area between contacting fluids. Also, multiple vortices are produced axially within flow passages, resulting in good mixing a heat exchange without a high penalty in pressure drop.

Additional features and advantages will be set forth in the detailed description which follows, and in part will be readily apparent to those skilled in the art from that description or recognized by practicing the embodiments as described herein, including the detailed description which follows, the claims, as well as the appended drawings.

It is to be understood that both the foregoing general description and the following detailed description are merely exemplary, and are intended to provide an overview or framework to understanding the nature and character of the claims. The accompanying drawings are included to provide a further understanding, and are incorporated in and constitute a part of this specification. The drawings illustrate one or more embodiment(s), and together with the description serve to explain principles and operation of the various embodiments.

### BRIEF DESCRIPTION OF THE DRAWINGS

Fig. 1 is a elevation view of a fluidic module formed of stacked structures;
Fig. 2 is an elevation view of a fluidic module formed of an alternative type of stacked structures;
Fig. 3 is an elevation view of a fluidic module formed of yet another alternative type of stacked structures;
Fig. 4 is a three-dimensional perspective view of fluid passages within a fluidic module 10 according to one aspect of the present disclosure;
Fig. 5 is a diagrammatic cross section viewed along the z-axis of the fluid passages of Fig. 4;
Fig. 6 is a partial diagrammatic cross-section viewed along the y axis of the fluid passages of Fig. 4;
Fig. 7 is a computer-generated three-dimensional perspective graphic of flow lines from a flow simulation of the fluid passages of Fig. 4 from a point of view similar to that of Fig. 4;
Fig. 8 is a view of the computer-generated three-dimensional graphic of flow lines of Fig. 7, viewed along the z-axis;
Fig. 9 is a view of the computer-generated three-dimensional graphic of flow lines of Fig. 7, viewed along the y-axis;
Fig. 10 is a partial diagrammatic cross-section similar to that of Fig. 6, but of an alternative embodiment of the present disclosure;
Fig. 11 is a diagrammatic view of the flow passages of Fig. 4, viewed along the z-axis.
Fig. 12 is a diagrammatic view of the same perspective as Fig. 11, but showing another alternative embodiment of the present disclosure;
Fig. 13 is a diagrammatic view of the same perspective as Figs. 11 and 12, but showing another alternative embodiment of the present disclosure;
Fig. 14 is a diagrammatic view of the same perspective as Figs. 11-13, but showing still another alternative embodiment of the present disclosure;
Fig. 15 is a three-dimensional perspective view of fluid passages within a fluidic module 10 according to another aspect of the present disclosure;
Fig. 16 is a three-dimensional perspective view of parallel fluid passages within a fluidic module 10 according to yet another aspect of the present disclosure; and
Fig. 17 is a three-dimensional perspective view of parallel fluid passages and thermal control fluid passages within a fluidic module 10 according to yet another aspect of the present disclosure.

### DETAILED DESCRIPTION

Reference will now be made in detail to embodiments, examples of which are illustrated in the accompanying drawings. Whenever possible, the same reference numerals will be used throughout the drawings to refer to the same or like parts.

Fig. 4 is a three-dimensional perspective view of fluid passages within a fluidic module 10 according to one aspect of the present disclosure. Fluid passages or fluid passage elements 16, 17, 20, 26 in the figure are represented in three-dimensional shading. The fluid passages form a mixer or "micromixer" 12 which is part of or contained within a fluid module 10.

As may be seen in Fig. 1, the module 10 takes the form of a multilayer microfluidic module having layers 51, 52, and 53 in which the micromixer 12 is contained. The micromixer includes various elements, in order along the internal fluid path (labeled 14 for reference). The first two in order are a first fluid channel 16 and an additional fluid channel 17. The fluid channel 16 lies within the first layer 51 of the module 10, along a first direction 15. The additional fluid channel 17, of which there is at least one (and only one, in this embodiment), also lies within the first layer 51 of the module 10, but along an additional direction 19.

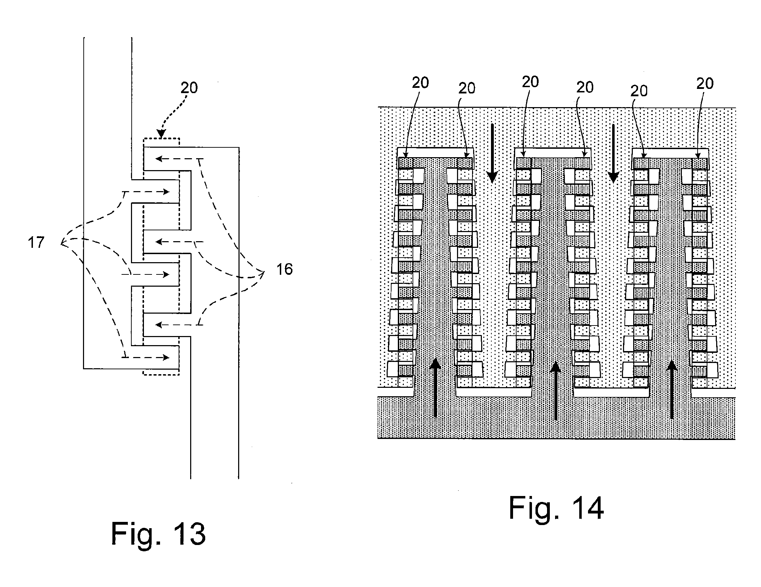

A first injection passage 20 extends from a first injection passage inlet 22 in at a lower boundary 21 of the first layer 51 of the module 10, through a second layer 52 of the module 10, to a first injection passage outlet 24. The first injection passage inlet 22 is fluidically connected to the first fluid channel 16 and to the additional fluid channel 17 via a manifold 25 within the first layer 51. In alternative embodiments to be discussed further hereinbelow with respect to Figs. 13 and 14, the first injection passage inlet 22 may be fluidically connected to the first fluid channel 16 and to the additional fluid channel 17 individually by direct connection through the lower boundary 21 of the first layer 51.

The module 10 of Fig. 4 further has a second fluid channel 26 lying within a third layer 53 of the module 10, the width of the second fluid channel 26 designated by the reference W₂₆.

The first direction 15 and the additional direction 19-along which the first fluid channel 16 and the additional fluid channel 17 approach each other within the first layer 51-can be non-collinear, and can (as in this embodiment) first join in a manifold 25 within the first layer 51, before exiting layer 51 via the inlet 22.

As may be seen in Fig. 1, the first injection passage outlet 24 is centered within the second fluid channel 26 in the direction of the width W₂₆. L₂₄ designates the length of the outlet 24 in the direction along the second fluid channel 26, and W₂₄ designates the width of the outlet 24 in the direction of the width W₂₆. According to the embodiments of the present disclosure, the width W₂₄ is narrower than the width W₂₆, and the first injection passage outlet 24 has a length-to-width ratio L₂₄ / W₂₄ of greater than 1:1.

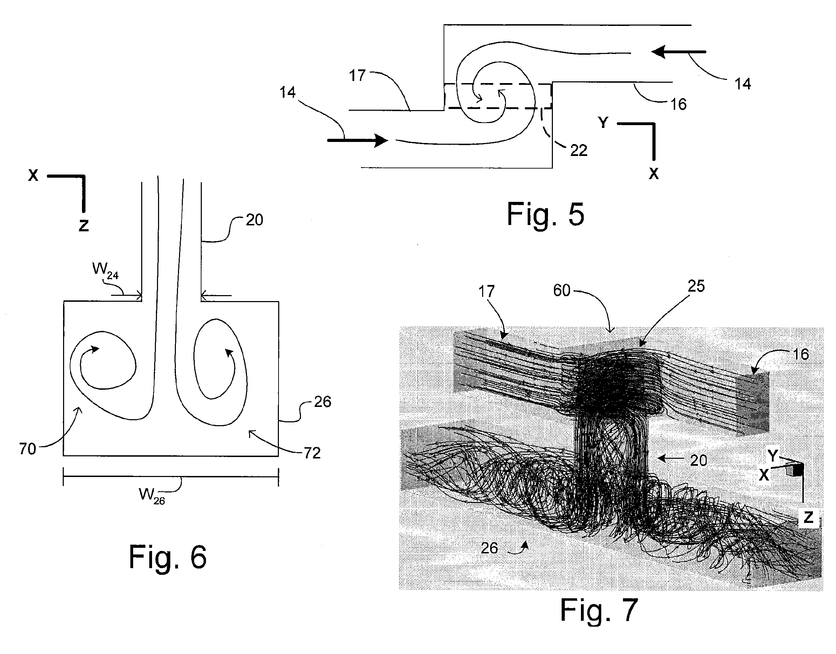

Some of the advantages produced by the structure of Fig. 4 are illustrated in Figures 5-9.

Figure 5 is a diagrammatic cross section, viewed along the z-axis, of the fluid passages of Fig. 4, showing how the offset or non-collinear approach toward and into the manifold 25 of the first fluid channel 16 and the alternative fluid channel 17, all within the first layer 51, produces a vortex flow 60 around the z-axis within the manifold 25. This acts to provide a pre-mixing or early mixing effect with a vortex 60 around a first axis (the z axis in the figures). From the manifold 25 the fluid flows into the inlet 22 and through the first injection passage 20.

Fig. 6 is a partial diagrammatic cross-section viewed along the y axis of the fluid passages of Fig. 4, showing how fluid flowing out of the first injection passage 20 through the outlet 24 forms two counter-rotating vortices 70, 72 within the second fluid channel 26. The rotation of vortices 70, 72 takes place simultaneously with movement of the fluid along the second fluid channel 26, resulting in a "dual-twist" flow or "dual-helical" flow within the second fluid channel 26. As seen from Figs. 5 and 6 in combination, the structure of Fig. 4 provides a fluid flow pattern, at first contact of two fluids, having a vortex flow around a first axis, flowed by a dual or multiple vortex flow around a second axis in a different orientation than the first axis (perpendicular to the first axis in this case). The quick change, within a short distance along the fluid path 14, from a z-axis rotation vortex to twin counter-rotating y-axis vortices results in complex and extensive stretching of the interfaces between the original two fluids entering the manifold 25, ensuring good mixing.

The width W₂₄ being narrower than the width W₂₆, as seen in Figs. 4 and 6, helps ensure the formation of the vortices 70, 72. That the first injection passage outlet 24 is longer than it is wide also encourages formation of the vortices 70, 72, as well as allowing lower pressure drop in the injection passage 20 than would otherwise be the case. For these purposes, the length-to-width ratio L₂₄ / W₂₄ is greater than 1:1. More desirably, length-to-width ratio L₂₄ / W₂₄ is least 2:1, even more desirably at least 4:1.

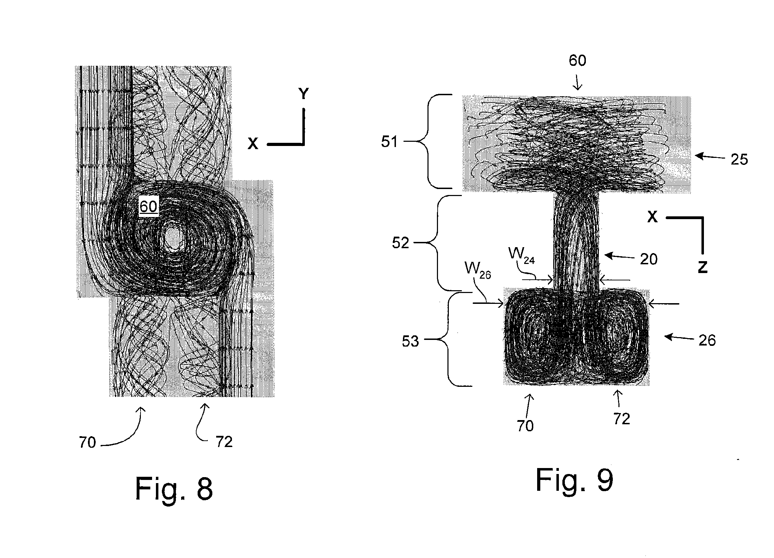

Figs. 7-9 are a computer-generated three-dimensional perspective graphics of flow lines from a flow simulation of a fluid in the passages of Fig. 4; Fig. 7 is from a point of view similar to that of Fig. 4, Fig. 8 is a view looking along the z-axis, while Fig. 9 is a view looking along the y-axis. These figures clearly show the vortex 60 around the z axis in the manifold 25, and the twin counter-rotating vortices 70 and 72 in the second fluid channel 26 in the third layer 53 of the module 10.

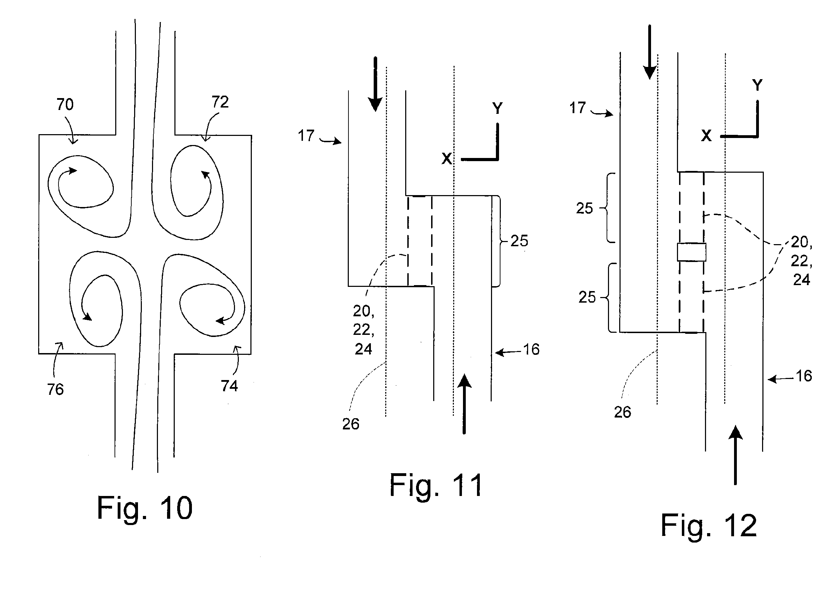

One alternative or additional embodiment to that of Fig. 4 is represented in Fig. 10, which is a partial diagrammatic cross-section similar to that of Fig. 6, but with this difference: an additional injection passage 20A opens into the second fluid channel 26 on the opposite side from the first injection passage 20. The two injection passages 20 and 20A together result in the formation of four vortices 70, 72, 74, 76 in parallel within the same channel, second fluid channel 26.

Fig. 11 is a diagrammatic view of the flow passages of Fig. 4, viewed along the z-axis, without flow lines flow indications to complicate the drawing, and with the walls of the second fluid channel 26 shown in dotted outline. Fig. 12 shows an alternative embodiment in which the first fluid channel 16 and the at least one additional fluid channel 17 meet at two points, in two manifolds 25 divided from each other, each with a first injection passage 20, such that multiple first injection passages (20) (in this case two) each have an outlet 24 centered within the second fluid channel 26.

Because the injection passages according to the present disclosure are intended for mixing by inducing vortices or twist flow, and not for injection of small flows into a larger flow, it is desirable that the hydraulic diameter of the outlet(s) 24 into a given second fluid channel 26 not be too much smaller than the hydraulic diameter of the given second fluid channel 26 itself. In other words, since pressure drop should be minimized, the total length(s) L₂₄ of the outlet or outlets 24 in a given second fluid channel 26 can be made relatively long to decrease the pressure drop caused by the first injection passage 20, and desirably are made sufficiently long (together with a sufficient width W₂₄, such that the total hydraulic diameter of the one or more injection passage(s) feeding a given second fluid passage 26 is not less than ½ the largest hydraulic diameter of the given second fluid passage 26, desirably not less than ¾.

Fig. 13 shows a diagrammatic view of the same perspective as Figs. 11 and 12, but showing another alternative embodiment of the present disclosure, according to which the first injection passage inlet 22 is fluidically connected to the first fluid channel 16 and to the additional fluid channel 17 individually through the lower boundary 21 of the first layer 51. In this embodiment, fluids coming in along the first fluid channel 16 and to the additional fluid channel 17 first contact each other within the first injection passage 20, as there is no manifold 25 within the first layer 51, but the multiple first fluid passages 16, in this case 3, interleave with multiple additional fluid passages 17, in this case 3, to produce multiple fluid interfaces within the first injection passage 20. This can be extended to numbers greater than three, and to multiple first injection passages in parallel, as shown in Fig. 14.

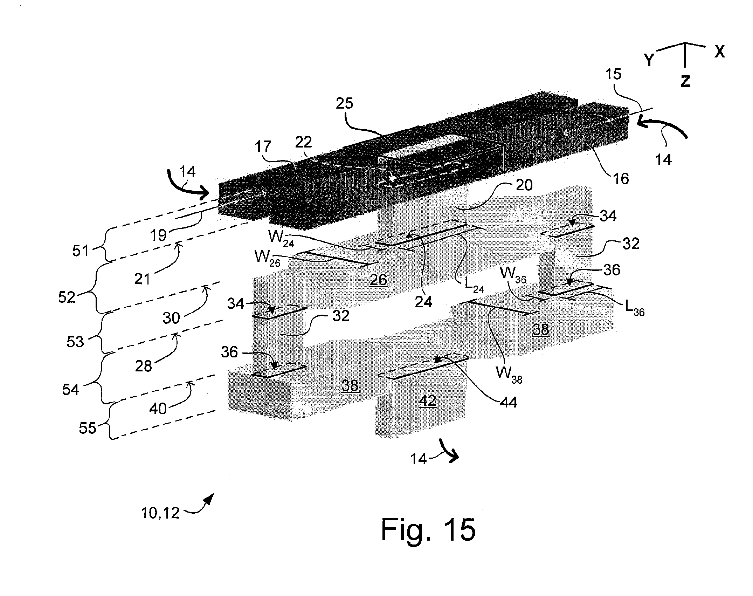

Fig. 15 is a three-dimensional perspective view of fluid passages within a fluidic module 10 according to another aspect of the present disclosure, similar to that of Fig. 4 but having additional layers 54 and 55, and also having a second injection passage 32 that extends orthogonally from a second injection passage inlet 34 in the a lower boundary 28 of the third layer 53, through the fourth layer 54 of the module 10 to a second injection passage outlet 36.

Cooperating with the second injection passage 32 is a third fluid channel 38 lying within a fifth layer 55 of the module 10, with the fifth layer 55 having a top boundary 40. Similarly to Fig. 4 described above, W₃₈, designates and represents the width of the third fluid channel 38, and the second injection passage outlet 36 is similarly centered within the second fluid channel 38 in the direction of the width W₃₈. Further, L₃₆ designates and represents the length of the outlet 36 along the second fluid channel 38. As above, the width W₃₆ is narrower than the width W₃₈, and the second injection passage outlet 36 has a length-to-width ratio L₃₆ / W₃₆ of greater than 1:1, desirably at least 2:1 or even at least 4:1. As may be seen at the bottom of Fig. 15, the mixing-promoting structures may repeat down through additional layers if desired, with a third injection passage 42 extending downward from the second fluid passage 26 via inlet 44, and so forth.

As an alternative embodiment and application for the structure shown in Fig. 15, the at least one additional fluid channel 17 may optionally be omitted from the first layer 51, in cases where the desired function is not the initial contacting of two fluids, but the continued mixing or stirring of a single feed. In this case, the first fluid channel 16 could optionally be centered over the injection passage 20. In such an embodiment generally, a multilayer micro fluidic module 10 organized in layers includes a micromixer 12 which itself includes various elements, in order along an internal fluid path 14. These include a first fluid channel 16 lying within a first layer 51 of the module 10, with the first layer 51 having a lower boundary 21; a first injection passage 20 extending orthogonally at a first injection passage inlet 22 from the lower boundary 21 of the first layer 51, through a second layer 52 of the module 10, to a first injection passage outlet 24; a second fluid channel 26 lying within a third layer 53 of the module 10, with the third layer 53 having a lower boundary 28 and an upper boundary 30, and with the second fluid channel having a width designated by W₂₆; a second injection passage 32 extending from a second injection passage inlet 34 in the lower boundary 28 of the third layer 53, through a fourth layer 54 of the module 10, to a second injection passage outlet 36; and a third fluid channel 38 lying within a fifth layer 55 of the module 10, the fifth layer 55 having a top boundary 40, the third fluid channel 38 having a width W₃₈.

In this embodiment, the first injection passage outlet 24 is centered within the second fluid channel 26 in the direction of the width W₂₆, and has a length L₂₄ along the second fluid channel 26 and a width W₂₄ in the direction of the width W₂₆, and the width W₂₄ is narrower than the width W₂₆, and the first injection passage outlet 24 has a length-to-width ratio L₂₄ / W₂₄ of at least 3:2.,

Further, the second injection passage outlet 36 is centered within the second fluid channel 38 in the direction of the width W₃₈, and has a length L₃₆ along the second fluid channel 38 and a width W₃₆ in the direction of the width W₃₈. As above, the width W₃₆ is narrower than the width W₃₈, and the second injection passage outlet 36 has a length-to-width ratio L₃₆ / W₃₆ of at least 3:2.

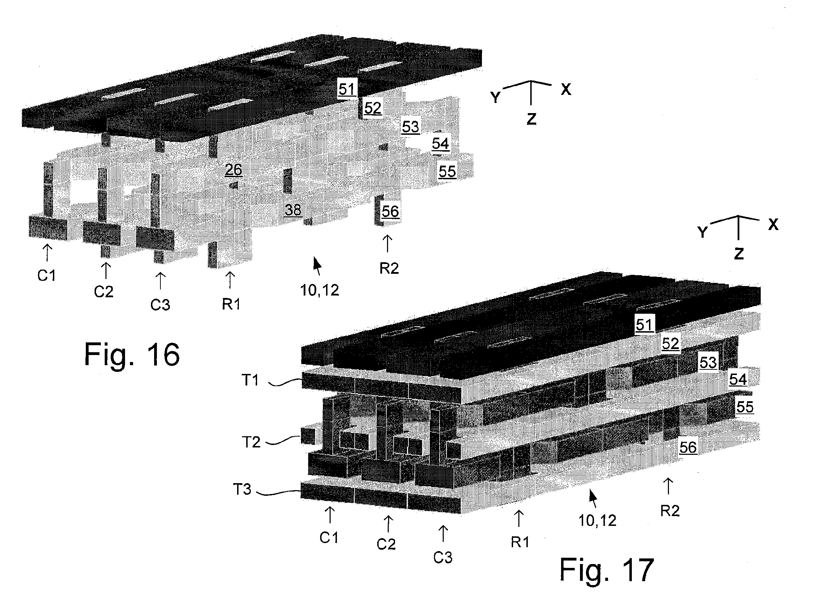

To achieve efficient use of the internal volume of a module 10 multiple mixer structures 12 like that of Fig. 15 may be employed in parallel. An example of the fluid paths for a module 10 of this type is shown in Figs. 16 and 17, which are three-dimensional perspective views of parallel fluid passages within a fluidic module 10 according to two more aspects of the present disclosure.

In the embodiment of Fig. 16, the module 10 comprises multiple second fluid channels 26 positioned, and intended to be fluidically connected, in parallel within the module 10. Only one such channel 26 can be seen directly from the side, but the columns C1-C3 correspond to three columns of second fluid channels 26 positioned in parallel within the device. As may be seen from inspection of Fig. 16, the embodiment of figure 16 also comprises two rows R1 and R2 of the embodiment of Fig. 15, such that the embodiment of Fig. 16 (and 17) is equivalent to a 2 X 3 array of the embodiment of Fig. 15. By building up a module 10 in this manner, a high percentage of the volume within layers 51, 54, and 55 is utilized. What would seem to be excess space in the layers containing the injection passages is in fact not excess at all, as it provides room for thermal control fluid passages T1, T2, and T3 as shown in Fig. 17. This allows for a thermal control passage between every "working fluid" layer, for best thermal control.

The present disclosure provides structures that create multiple simultaneous circulations in an axial direction within a given fluid channel. This forms a large interfacial area between the mixing components and improves heat exchange without significantly increased pressure drop. According to a further aspect of the present disclosure structures are provided that induce, axial circulations sequentially along sections of fluid channel not lying in the same plane, such that vortexes are formed sequentially at angles to each other, desirably at right angles, producing a further increase in the resulting interfacial area between contacting fluids.

The methods and/or devices disclosed herein are generally useful in performing any process that involves mixing, separation, extraction, crystallization, precipitation, or otherwise processing fluids or mixtures of fluids, including multiphase mixtures of fluids-and including fluids or mixtures of fluids including multiphase mixtures of fluids that also contain solids-within a microstructure. The processing may include a physical process, a chemical reaction defined as a process that results in the interconversion of organic, inorganic, or both organic and inorganic species, a biochemical process, or any other form of processing. The following non-limiting list of reactions may be performed with the disclosed methods and/or devices: oxidation; reduction; substitution; elimination; addition; ligand exchange; metal exchange; and ion exchange. More specifically, reactions of any of the following non-limiting list may be performed with the disclosed methods and/or devices: polymerisation; alkylation; dealkylation; nitration; peroxidation; sulfoxidation; epoxidation; ammoxidation; hydrogenation; dehydrogenation; organometallic reactions; precious metal chemistry/ homogeneous catalyst reactions; carbonylation; thiocarbonylation; alkoxylation; halogenation; dehydrohalogenation; dehalogenation; hydroformylation; carboxylation; decarboxylation; amination; arylation; peptide coupling; aldol condensation; cyclocondensation; dehydrocyclization; esterification; amidation; heterocyclic synthesis; dehydration; alcoholysis; hydrolysis; ammonolysis; etherification; enzymatic synthesis; ketalization; saponification; isomerisation; quaternization; formylation; phase transfer reactions; silylations; nitrile synthesis; phosphorylation; ozonolysis; azide chemistry; metathesis; hydrosilylation; coupling reactions; and enzymatic reactions.

## Claims

1. A multilayer microfluidic module (10) comprising a micro mixer (12), the micromixer (12) comprising, in order along an internal fluid path (14):
a first fluid channel (16) lying within a first layer (51) of the module (10) along a first direction (15), the first layer having a lower boundary (21);
at least one additional fluid channel (17) lying within the first layer (51) of the module (10) along an additional direction (19);
a first injection passage (20) extending from a first injection passage inlet (22) in the lower boundary (21) of the first layer (51) of the module (10) through a second layer (52) of the module (10) to a first injection passage outlet (24), the first injection passage inlet (22) being fluidically connected to the first fluid channel (16) and to the additional fluid channel (17) either individually through the lower boundary (21) of the first layer (51) or via a manifold (25) within the first layer (51); and
a second fluid channel (26) lying within a third layer (53) of the module (10), the third layer (53) having an upper boundary (30), the second fluid channel having a width W₂₆;
wherein the first direction (15) and the additional direction (19)-along which the respective first fluid channel (16) and additional fluid channel (17) approach each other within the first layer (51)-are non-collinear, and
wherein the first injection passage outlet (24) is centered within the second fluid channel (26) in the direction of the width W₂₆, and has a length L₂₄ along the second fluid channel (26) and a width W₂₄ in the direction of the width W₂₆ **characterized in that** the width
W₂₄ is narrower than the width W₂₆, and the first injection passage outlet (24) has a length-to-width ratio L₂₄ / W₂₄ of greater than 1:1.

2. The module according to claim 1 wherein the first injection passage outlet (24) has a length-to-width ratio L₂₄ / W₂₄ of at least 2:1.

3. The microfluidic module according to claim 1 wherein the first injection passage outlet (24) has a length-to-width ratio L₂₄ / W₂₄ of at least 4:1.

4. The microfluidic module according to any of claims 1-3 wherein the module (10) further comprises multiple first fluid channels (16) and multiple additional fluid channels (17) within the first layer (51) of the module (10), and wherein the first injection passage (20) is fluidically connected to the multiple first fluid channels (16) and to the multiple additional fluid channels (17) either individually through the lower boundary (21) of the first layer (51) or via a manifold (25) within the first layer (51).

5. The microfluidic module according to any of claims 1-3 wherein the module (10) further comprises multiple first injection passages (20) each having an outlet (24) centered within the second fluid channel (26) in the direction of the width W₂₆.

6. The microfluidic module according to any of claims 1-5 wherein a total hydraulic diameter of all of the outlets (24) within a respective second fluid channel 26 is at least 1/2 of a hydraulic diameter of the respective second fluid channel 26 at the position of the outlet(s) (24).

7. The microfluidic module according to any of claims 1-6 wherein the module (10) comprises multiple second fluid channels (26) positioned, and fluidically connected, in parallel within the module (10).

8. The microfluidic module according to any of claims 1-7 further comprising a second injection passage (32) extending orthogonally, from a second injection passage inlet (34) in the lower boundary (28) of the third layer (53), through a fourth layer (54) of the module (10), to a second injection passage outlet (36); and a third fluid channel (38) lying within a fifth layer (55) of the module (10), the fifth layer (55) having a top boundary (40), the third fluid channel (38) having a width W₃₈, wherein the second injection passage outlet (36) is centered within the second fluid channel (38) in the direction of the width W₃₈, and has a length L₃₆ along the second fluid channel (38) and a width W₃₆ in the direction of the width W₃₈, and wherein the width W₃₆ is narrower than the width W₃₈, and wherein the second injection passage outlet (36) has a length-to-width ratio L₃₆ / W₃₆ of at least 3:2

9. The microfluidic module according to any of claims 1-7 further comprising at least one thermal control fluid passage (T1) contained within a layer (52) through which pass, orthogonally to the main direction of the thermal control fluid passage (T1), one or more first injection passages 20.

10. The microfluidic module according to any of claims 1-7 further comprising multiple thermal control fluid passage (T1,T2,T3) each contained within a layer (52,54,56) through which pass, orthogonally to the main direction of the thermal control fluid passage (T1,T2,T3), one or more first, second, or third injection passages (20,32,40).

## Patentansprüche

1. Mehrschichtiges mikrofluidisches Modul (10), das einen Mikromixer (12) umfasst, wobei der Mikromixer (12) geordnet, entlang eines internen Fluidpfads (14) Folgendes umfasst:
einen ersten Fluidkanal (16), der in einer ersten Schicht (51) des Moduls (10) entlang einer ersten Richtung (15) liegt, wobei die erste Schicht eine untere Begrenzung (21) aufweist;
mindestens einen zusätzlichen Fluidkanal (17), der innerhalb der ersten Schicht (51) des Moduls (10) entlang einer zusätzlichen Richtung (19) liegt;
eine erste Einspritzpassage (20), die sich von einem ersten Einspritzpassageneinlass (22) in der unteren Begrenzung (21) der ersten Schicht (51) des Moduls (10) durch eine zweite Schicht (52) des Moduls (10) zu einem ersten Einspritzpassagenauslass (24) ausdehnt, wobei der erste Einspritzpassageneinlass (22) fluidisch mit dem ersten Fluidkanal (16) und dem zusätzlichen Fluidkanal (17) entweder individuell durch die untere Begrenzung (21) der ersten Schicht (51) oder über einen Verteiler (25) innerhalb der ersten Schicht (51) verbunden ist; und
einen zweiten Fluidkanal (26), der innerhalb einer dritten Schicht (53) des Moduls (10) liegt, wobei die dritte Schicht (53) eine obere Begrenzung (30) aufweist, wobei der zweite Fluidkanal eine Breite W₂₆ aufweist;
wobei die erste Richtung (15) und die zusätzliche Richtung (19) - entlang welcher sich der jeweilige erste Fluidkanal (16) und der zusätzliche Fluidkanal (17) einander innerhalb der ersten Schicht (51) annähern - nicht kollinear sind, und
wobei der erste Einspritzpassagenauslass (24) innerhalb des zweiten Fluidkanals (26) in der Richtung der Breite W₂₆ zentriert ist und eine Länge L₂₄ entlang des zweiten Fluidkanals (26) und eine Breite W₂₄ in Richtung der Breite W₂₆ aufweist, dadurch charakterisiert, dass die Breite W₂₄ schmaler als die Breite W₂₆ ist, und der erste Einspritzpassagenauslass (24) weist ein Länge-Breite-Verhältnis L₂₄ / W₂₄ auf, das größer als 1:1 ist.

2. Modul nach Anspruch 1, wobei der erste Einspritzpassagenauslass (24) ein Länge-Breite-Verhältnis L₂₄ / W₂₄ von mindestens 2:1 aufweist.

3. Mikrofluidisches Modul nach Anspruch 1, wobei der erste Einspritzpassagenauslass (24) ein Länge-Breite-Verhältnis L₂₄ / W₂₄ von mindestens 4:1 aufweist.

4. Mikrofluidisches Modul nach einem beliebigen der Ansprüche 1-3, wobei das Modul (10) zusätzlich mehrere erste Fluidkanäle (16) und mehrere zusätzliche Fluidkanäle (17) innerhalb der ersten Schicht (51) des Moduls (10) umfasst, und wobei die erste Einspritzpassage (20) fluidisch mit den mehreren ersten Fluidkanälen (16) und den mehreren zusätzlichen Fluidkanälen (17) entweder individuell durch die untere Begrenzung (21) der ersten Schicht (51) oder über einen Verteiler (25) innerhalb der ersten Schicht (51) verbunden ist.

5. Mikrofluidisches Modul nach einem beliebigen der Ansprüche 1-3, wobei das Modul (10) zusätzlich mehrere erste Einspritzpassagen (20) umfasst, die jeweils einen Auslass (24) aufweisen, der innerhalb des zweiten Fluidkanals (26) in der Richtung der Breite W₂₆ zentriert ist.

6. Mikrofluidisches Modul nach einem beliebigen der Ansprüche 1-5, wobei ein gesamter hydraulischer Durchmesser aller Auslässe (24) innerhalb eines jeweiligen zweiten Fluidkanals 26 mindestens 1/2 des hydraulischen Durchmessers des jeweiligen zweiten Fluidkanals 26 an der Position des Auslasses/der Auslässe (24) entspricht.

7. Mikrofluidisches Modul nach einem beliebigen der Ansprüche 1-6, wobei das Modul (10) mehrere zweite Fluidkanäle (26) umfasst, die parallel in dem Modul (10) positioniert und in diesem fluidisch verbunden sind.

8. Mikrofluidisches Modul nach einem beliebigen der Ansprüche 1-7, das zusätzlich Folgendes umfasst: eine zweite Einspritzpassage (32), die sich orthogonal von einem zweiten Einspritzpassageneinlass (34) in der unteren Begrenzung (28) der dritten Schicht (53) durch eine vierte Schicht (54) des Moduls (10) zu einem zweiten Einspritzpassagenauslass (36) ausdehnt; und einen dritten Fluidkanal (38), der innerhalb einer fünften Schicht (55) des Moduls (10) liegt, wobei die fünfte Schicht (55) eine obere Begrenzung (40) aufweist, wobei der dritte Fluidkanal (38) eine Breite W₃₈ aufweist, wobei der zweite Einspritzpassagenauslass (36) innerhalb des zweiten Fluidkanals (38) in der Richtung der Breite W₃₈ zentriert ist und eine Länge L₃₆ entlang des zweiten Fluidkanals (38) und eine Breite W₃₆ in Richtung der Breite W₃₈ aufweist, und wobei die Breite W₃₆ schmaler als die Breite W₃₈ ist, und wobei der zweite Einspritzpassagenauslass (36) ein Länge-Breite-Verhältnis L₃₆ / W₃₆ von mindestens 3:2 aufweist.

9. Mikrofluidisches Modul nach einem beliebigen der Ansprüche 1-7, das zusätzlich mindestens eine Fluidpassage für die thermische Steuerung (T1) umfasst, die in einer Schicht (52) enthalten ist, durch welche orthogonal zur Hauptrichtung der Fluidpassage für die thermische Steuerung (T1) eine oder mehrere erste Einspritzpassagen 20 verlaufen.

10. Mikrofluidisches Modul nach einem beliebigen der Ansprüche 1-7, das zusätzlich mehrere Fluidpassagen für die thermische Steuerung (T1, T2, T3) umfasst, die jeweils in einer Schicht (52, 54, 56) enthalten sind, durch welche orthogonal zur Hauptrichtung der Fluidpassage für die thermische Steuerung (T1, T2, T3) eine oder mehrere erste, zweite oder dritte Einspritzpassagen (20, 32, 40) verlaufen.

## Revendications

1. Module microfluidique multicouche (10) comprenant un micromélangeur (12), le micromélangeur (12) comprenant, dans cet ordre le long d'un circuit de fluide interne (14):
un premier canal de fluide (16) situé dans une première couche (51) du module (10) le long d'une première direction (15), la première couche ayant une limite inférieure (21) ;
au moins un canal de fluide supplémentaire (17) situé dans une première couche (51) du module (10) le long d'une première direction (19) ;
un premier passage d'injection (20) s'étendant à partir d'une première entrée de passage d'injection (22) dans la limite inférieure (21) de la première couche (51) du module (10) à travers une seconde couche (52) du module (10) vers une première sortie de passage d'injection (24), la première entrée de passage d'injection (22) étant connectée de manière fluide avec le premier canal de fluide (16) et avec le canal de fluide supplémentaire (17) soit individuellement à travers la limite inférieure (21) de la première couche (51) soit à travers un collecteur (25) dans la première couche (51) et
un second canal de fluide (26) situé dans une troisième couche (53) du module (10), la troisième couche (53) ayant une limite supérieure (30), le second canal de fluide ayant une largeur W_{26;}
où la première direction (15) et la direction supplémentaire (19) - le long desquelles le premier canal de fluide (16) et le canal de fluide supplémentaire (17) respectifs s'approchent l'un de l'autre dans la première couche (51) - sont non colinéaires, et
où la première sortie de passage d'injection (24) est centrée dans le second canal de fluide (26) dans la direction de la largeur W₂₆, et présente une longueur L₂₄ le long du second canal de fluide (26) et une largeur W₂₄ dans la direction de la largeur W₂₆ **caractérisé en ce que**
la largeur
W₂₄ est plus étroite que la largeur W₂₆, et la première sortie de passage d'injection (24) présente un rapport longueur/largeur L₂₄ / W₂₄ supérieur à 1:1.

2. Module selon la revendication 1, où la première sortie de passage d'injection (24) présente un rapport longueur/largeur L₂₄ / W₂₄ d'au moins 2:1.

3. Module microfluidique selon la revendication 1, où la première sortie de passage d'injection (24) présente un rapport longueur/largeur L₂₄ / W₂₄ d'au moins 4:1.

4. Module microfluidique selon l'une quelconque des revendications 1 à 3, où le module (10) comprend en outre de multiples premiers canaux de liquide (16) et de multiples canaux de liquide supplémentaires (17) dans la première couche (51) du module (10), et où le premier passage d'injection (20) est connecté de manière fluide avec les multiples premiers canaux de liquide (16) et les multiples canaux de liquide supplémentaires (17) soit individuellement à travers la limite inférieure (21) de la première couche (51) soit à travers un collecteur (25) dans la première couche (51).

5. Module microfluidique selon l'une quelconque des revendications 1 à 3, où le module (10) comprend en outre de multiples premières passages d'injection (20) chacun ayant une sortie (24) centrée dans le second canal de fluide (26) dans la direction de la largeur W₂₆.

6. Module microfluidique selon l'une quelconque des revendications 1 à 5, où un diamètre hydraulique total de toutes les sorties (24) dans un second canal de fluide respectif 26 est d'au moins la moitié d'un diamètre hydraulique du second canal de fluide 26 à la position des sorties (24).

7. Module microfluidique selon l'une quelconque des revendications 1 à 6, où le module (10) comprend de multiples seconds canaux de fluide (26) positionnés, et connectés de manière fluide, en parallèle dans le module (10).

8. Module microfluidique selon l'une quelconque des revendications 1 à 7, comprenant en outre un second passage d'injection (32) s'étendant de manière orthogonale, à partir d'une seconde entrée de passage d'injection (34) dans la limite inférieure (28) de la troisième couche (53), à travers une quatrième couche (54) du module (10), vers une deuxième sortie de passage d'injection (36) ; et un troisième canal de fluide (38) situé dans une cinquième couche (55) du module (10), la cinquième couche (55) ayant une limite supérieure (40), le troisième canal de fluide (38) ayant une largeur W₃₈, où la deuxième sortie de passage d'injection (36) est centrée dans le second canal de fluide (38) dans la direction de la largeur W₃₈, et présente une longueur L₃₆ le long du second canal de fluide (38) et une largeur W₃₆ dans la direction de la largeur W₃₈, et où la largeur W₃₆ est plus étroite que la largeur W₃₈, où la deuxième sortie de passage d'injection (36) présente un rapport longueur/largeur L₃₆ / W₃₆ d'au moins 3:2.

9. Module microfluidique selon l'une quelconque des revendications 1 à 7, comprenant en outre au moins un passage de fluide de contrôle thermique (Tl) contenu dans une couche (52) à travers laquelle passent, de manière orthogonale à la direction du passage de fluide de contrôle thermique (Tl), un ou plusieurs premiers passages d'injection (20).

10. Module microfluidique selon l'une quelconque des revendications 1 à 7, comprenant en outre de multiples passages de fluide de contrôle thermique (T1, T2, T3) chacun contenu dans une couche (52, 54, 56) à travers laquelle passent, de manière orthogonale à la direction du passage de fluide de contrôle thermique (T1, T2, T3), un ou plusieurs premiers, deuxièmes ou troisièmes passages d'injection (20, 32, 40).
